# DEMANDE DE BREVET EUROPEEN

(11) **EP 2 273 360 A1**
(43) Date de publication de la demande: **12.01.2011**
(21) Numéro de dépôt: 10168200.3
(22) Date de dépôt: 02.07.2010
(51) Int. Cl.: G06F 9/44

(54) **Procédé de création d'une bibliothèque de représentations algorithmiques d'équipements électroniques**

(30) Priorité: 08.07.2009 FR 0954738
(71) Demandeur: Airbus Operations (S.A.S.), 31060 Toulouse (FR)
(72) Inventeur: Baccou, Alain, 31820 Pibrac (FR); Marin, Patrice, 31810 Clermont le Fort (FR)
(74) Mandataire: Fourcade, Emmanuelle

(57) **Abrégé**

L'invention vise un procédé de création d'une bibliothèque de semi-équipements S-E-Library, lesdits semi-équipements, définis par des normes prédéterminées, étant destinés à être intégrés dans au moins un système électronique,
la bibliothèque de semi-équipements S-E-Library comportant pour au moins un semi-équipement un algorithme de fonctionnement logique le représentant, présenté sous forme de blocs génériques de simulation (schémas fonctionnels graphiques formels), compatibles avec un langage de simulation. Les blocs génériques de simulation possèdent des entrées et des sorties identifiées.

Le procédé comporte des sous-étapes de :
1 - listage toutes les normes correspondant à tous les composants reliés aux extrémités de câbles d'un sous-système électronique que l'on veut simuler,
2 - codage, pour chaque norme, du semi-équipement correspondant, cette sous-étape comprenant des phases :
2a - d'analyse de la nomenclature et de l'algorithme de fonctionnement du semi-équipement,
2b - de codage de la logique du semi-équipement dans un bloc de simulation, sous forme de schéma fonctionnel graphique formel, interprétable par un logiciel de simulation.

## Description

L'invention relève du domaine général de la simulation. Plus particulièrement, elle concerne la simulation de fonctionnement de véhicule, telle que par exemple utilisée dans des simulateurs de vol.

### Contexte de l'invention et problèmes posés

Dans le domaine aéronautique, des simulateurs de fonctionnement de l'aéronef sont utilisés depuis de nombreuses années, tant pour la familiarisation des pilotes à la disposition du cockpit d'un aéronef nouveau et au comportement des équipements de l'aéronef lors de leurs actions dans ce cockpit, que pour la mise au point initiale des aéronefs.

De tels simulateurs doivent être extrêmement fidèles au fonctionnement de l'aéronef simulé, lequel est en fait constitué d'un ensemble de milliers d'équipements reliés ensembles.

Techniquement, on distingue plusieurs étapes dans la simulation d'un programme avion :
La simulation de développement qui constitue la simulation initiale des composants avioniques dans un univers simulé par le biais de PC notamment.
La simulation dite d'intégration qui correspond à une campagne de tests menée avec des calculateurs réels. On effectue très souvent les essais par le biais d'un banc général appelé qui reprend notamment l'ensemble des circuits électriques et hydrauliques à l'échelle 1, permettant de valider l'ensemble des systèmes afin de préparer le premier vol.
La simulation d'intégration sert ainsi à tester la validité de la conception avion et ne comporte tout d'abord que des équipements simulés. Elle intègre ensuite des composants réels embarqués sur l'avion réel et suit ainsi toute la phase d'étude de l'avion final.

Quant à la simulation d'entraînement, elle représente l'étape finale de la conception, elle sert à entraîner pilotes et personnel de maintenance et doit en ce sens être une représentation la pus fidèle possible de la réalité.

Le cockpit de l'aéronef simulé est alors reconstitué de façon visuellement analogue au cockpit réel, et l'interface apparente de chaque équipement de pilotage est rendue de façon aussi proche que possible de la réalité. Les autres équipements de l'avion peuvent être simulés.

Le fonctionnement de chaque équipement est le plus souvent simulé par moyen informatique, son état à chaque instant étant déterminé en fonction des données reçues de la part d'autres équipements, et de règles algorithmiques de fonctionnement dudit équipement. En retour, l'équipement envoie à certains autres équipements des informations sur son état.

En général, ces modèles de simulation sont codés en utilisant un méta langage sous forme de schémas fonctionnels graphiques formels, par exemple codés en langage XML, puis transformés par un module de codage automatique en code C, représentatif d'un graphe et de noeuds de simulation, et directement exécutable par un simulateur avion.

Un tel logiciel de simulation, par exemple un logiciel commercial de type SCADE (marque déposée), est un environnement de développement intégré utilisé pour concevoir, simuler, vérifier et développer le code embarqué des systèmes temps-réel critiques, tels que les équipements aéronautiques, les systèmes automobiles ou les systèmes de signalisation ferroviaires.

Un tel langage est à la fois un langage de type schématique (avec des représentations graphiques), et un langage formel basé sur des règles sémantiques structurées, de façon analogue au langage XML.

Ce type de logiciel de simulation s'apparente au logiciel connu sous le nom commercial 'Matlab Simulink' (marque déposée). Il utilise des schémas fonctionnels graphiques formels (conception par modèles) pour des spécifications précises et un dialogue facilité. Il s'agit d'un logiciel dit temps synchrone, tel qu'apparu dans les années 80. Une fois décrites, les spécifications peuvent être exécutées.

D'un point de vue théorique, ces langages de simulation "manipulent des suites infinies, chacune de ces suites représentant l'évolution d'un signal d'entrée / sortie du système au cours du temps"(Pouzet, thèse 2007). Dans un modèle temps synchrone, tous les processus mis en parallèle partagent une même échelle de temps globale.

Le simulateur avion sur lequel doit être mis en oeuvre le procédé selon l'invention utilise le code de type C généré par le logiciel de simulation. En mode graphique interactif, le simulateur est un outil très puissant de détection d'erreurs de conception ou de problèmes de fonctionnement ou de compatibilité entre équipements, lors de l'étape de conception de systèmes avion.

Le code embarqué en langage C ou Ada est généré automatiquement à partir du modèle de schémas fonctionnels graphiques formels créé par les développeurs de modèles (« Model Developers » en langue anglo-saxonne), et est considéré qualifié pour être embarqué à bord des appareils munis de système temps-réels. L'importance de la validité de ce code est donc évidente, de même que sa disponibilité rapide lors de la phase de conception et de test.

Chaque équipement est donc soit intégré dans le simulateur de façon réelle, soit simulé sous forme logicielle, les différents blocs logiciels correspondant aux équipements échangeant des informations entre eux de façon conforme au schéma de câblage de l'aéronef réel.

La simulation du schéma de câblage est donc un élément essentiel de toute simulation fonctionnelle de l'aéronef.

On inclue ici dans la définition du câblage non seulement les fils proprement dits, mais aussi des éléments simples nommés semi-équipements, dont la complexité est très inférieure aux équipements de l'aéronef. Ces semi-équipements peuvent par exemple comporter des relais, des coupe-circuits, etc. Leur fonctionnement doit également être simulé.

On comprend que, autant les différents équipements sont de nature standard et leurs algorithmes peuvent être représentés de façon logicielle inchangée, quelle que soit l'utilisation de l'équipement, autant le câblage de ces équipements entre eux peut varier d'un aéronef à l'autre, en fonction par exemple des exigences d'aménagement et de fonctionnement des différents clients d'un modèle d'aéronef, entraînant à chaque fois un schéma de câblage spécifique.

Chacun de ces schémas de câblage doit alors être testé, tant pour évaluer son bon fonctionnement en phase de conception, que pour être simulé dans un simulateur de vol général de l'aéronef, ou pour en tester des modes de fonctionnement dégradés en cas de panne d'un ensemble d'éléments de câblage ou d'équipements.

En dehors d'une utilisation dans ces simulateurs de vol dotés d'interfaces d'affichage sophistiquées, l'évaluation fonctionnelle d'un schéma de câblage peut également être rendue nécessaire par des modifications de ce câblage entre deux aéronefs produits, pour vérifier le bon fonctionnement dudit câblage. Une simulation numérique de ce câblage est alors souhaitable, pour tester, selon une valeur d'entrée en un point du schéma, les valeurs de sortie en divers autres points du schéma.

Dans ces deux cas, les lignes de code logiciel correspondant au schéma de câblage des équipements entre eux sont actuellement créées manuellement pour chaque nouvelle configuration de câblage. Ceci entraîne des temps de développement très significatifs, et constitue une source d'erreurs inévitable, quand on considère les dizaines de milliers de câbles de connexion présents dans un aéronef actuel.

Le coût associé à chaque simulation est également significatif, et le temps entre deux simulations successives lors de la conception d'un schéma de câblage pour validation est considérable.

La présente invention a donc pour objet de remédier à ces inconvénients en proposant un procédé de création de simulation de câblage qui soit automatique.

Un second but de l'invention est alors de réduire significativement le temps et le coût de chaque création de simulation de schéma de câblage.

Un troisième but de l'invention est de permettre la prise en compte d'une série de semi-équipements dans la création automatique de simulation.

### Exposé de l'invention

A cet effet, l'invention vise en premier lieu un procédé de génération de simulation numérique fonctionnelle d'un système électronique à partir d'une base de spécifications de câblage BD1 de ce système électronique,
ledit système électronique comprenant des équipements, au moins un câble de connexion reliant entre eux des équipements,
ladite base de spécifications de câblage BD1 listant de façon exhaustive les entrées et sorties de chaque câble de ce système électronique et comprenant notamment pour chaque câble : la nomenclature de ses deux extrémités, le type d'équipement relié à chaque extrémité, et les références de cet équipement, le système ou sous-système duquel dépend le câble,
le procédé comportant des étapes :
101 - de création d'une table de câblage BD2 par sélection et extraction de données de la base de spécifications de câblage BD1, ladite table de câblage BD2 comprenant au moins pour chaque câble du système électronique à simuler, et pour chaque extrémité dudit câble, la référence de l'équipement auquel elle est connectée, et une catégorie de classement dudit équipement,
104 - de création d'une table de simulation TS par transformation de chaque ligne de la table de câblage BD2 en utilisant des règles de transformation spécifiques à chaque couple d'équipements connectés aux deux extrémités de chaque câble,
105 - de création d'un ensemble d'instructions de code informatique interprétable par un simulateur, par transformation de chaque ligne de la table de simulation TS en un ensemble de lignes de code informatique selon les équipements d'entrée et de sortie.

On comprend qu'on créé ainsi un procédé de création de simulation sans intervention du développeur de modèles (« model developer »), et en s'affranchissant donc à la fois du travail fastidieux de codage fil à fil de celui-ci et des erreurs éventuelles de codage.

En observant la récurrence de semi-composants similaires dans les planches de câblage qui étaient précédemment recodés à chaque redondance du fait de la procédure manuelle, on a donc obtenu :
- Une amélioration de productivité et d'efficacité dans la génération de modèles ;
- Une réduction des sources d'erreurs du fait du codage récurrent des semi-équipements, et donc validation plus rapide des modèles ;
- Une traçabilité meilleure des modèles développés.

Selon une mise en oeuvre particulière du procédé, celui-ci comprend également une étape :
102 - de création d'une bibliothèque de semi-équipements S-E-Library définissant pour un ensemble d'au moins un équipement du système électronique dit semi-équipement un algorithme de fonctionnement logique, mémorisé sous forme de schéma fonctionnel graphique formel utilisant des blocs élémentaires de représentation prédéfinis.

Cette disposition correspond à la prise en compte de semi-équipements, qui ne sont pas des câbles proprement dits, mais qui opèrent selon un algorithme logique très simple au regard des équipements majeurs de l'aéronef.

Selon une mise en oeuvre particulière du procédé, celui-ci comprend en outre une étape :
103 - d'intégration des composants listés dans la table de câblage BD2 dans un méta modèle de simulation, sous forme de schémas fonctionnels graphiques formels en un seul noeud ou en plusieurs noeuds, chaque noeud représentant un système.

Selon une mise en oeuvre avantageuse, dans le modèle généré, chaque noeud de simulation, simule un système et chaque équation de ce noeud simule les sous-systèmes correspondants.

Selon une mise en oeuvre particulière du procédé, l'étape 104 de création d'une table de simulation TS, met en oeuvre une fonction de connexion, écrite dans un logiciel de simulation travaillant sous forme de blocs graphiques fonctionnels, ayant pour but de relier les entrées et les sorties des composants grâce à la base de données BD1 d'entrées et sorties de câblages,
les deux entrées de cette fonction de connexion étant :
1 / d'une part, la table de câblage BD2 des entrées et sorties de chaque câble avion,
2/ d'autre part, la trame du méta modèle de simulation, c'est à dire les blocs de simulation des équipements et sous-équipements, extraits de la bibliothèque S-E-Library, si ils font partie des composants reliés aux extrémités de câbles listés dans la table de câblage BD2.

Selon une mise en oeuvre particulière du procédé, la fonction de connexion
parcourt la table de câblage BD2 ligne à ligne, et
procède au fur et à mesure au chargement des blocs logiciels de simulation de la bibliothèque de semi-équipements S-E-Library correspondant aux composants d'extrémités de câbles, incorporés au code sous forme de procédures,
puis effectue le traitement des câbles eux-mêmes
par la détermination du sens de parcours du courant qui les traverse, et leur codage équivalent.

Selon une mise en oeuvre particulière du procédé, dans l'étape 104
la détermination, pour toutes les origines et destinations des câbles du système électronique, de leur nature entrée ou sortie, utilise un algorithme comme suit :
1/ pour tous les composants listés dans la bibliothèque S-E-Library, on définit les liens possibles entre les broches des connecteurs de ce composant,
2/ puis on fixe au moins une des extrémités d'un câble du système électronique comme devant obligatoirement être une entrée ou une sortie, à partir d'un ensemble de règles initiales utilisant la définition graphique formelle des semi-équipements,
3/ puis on propage, par cheminement d'une extrémité d'un composant à une autre extrémité de ce composant, et d'une extrémité d'un câble à l'autre extrémité de ce même câble, la nature des différentes extrémités de tous les câbles du système à simuler.

Cette mise en oeuvre permet de déterminer de proche en proche le sens des différents câbles d'une planche de câblage, en utilisant la logique interne de chaque composant, qui contraint la nature d'un certain nombre de broches et donc d'extrémités de câbles. La propagation "virale" de la nature des extrémités de câbles permet alors d'établir toutes les natures des extrémités de câbles.

Selon une mise en oeuvre particulière du procédé, la base de données de spécifications de câblage BD1 comprend également pour chaque câble des renvois aux planches de câblage incluant les positions auxquelles ce composant doit être dessiné sur la planche de câblage,
la table de câblage BD2 correspond à au moins une planche de câblage,
dans l'étape 101, la table de câblage BD2 comprend également les coordonnées de dessin de chaque composant sur chaque planche de câblage.
et la table de simulation TS comprend également des coordonnées de dessin de chaque bloc de simulation d'un composant sur une planche de simulation, ces coordonnées étant choisies identiques aux coordonnées de dessin dudit composant dans la table de câblage BD2.

Cette disposition permet au développeur de modèles (« model developer ») d'effectuer visuellement très facilement une première vérification de conformité du modèle de câblage avec la planche de câblage originale, la planche de simulation s'y superposant composant à composant.

Selon une mise en oeuvre particulière du procédé, la table de simulation TS est créée dans un langage graphique de type XML.

L'invention vise également un produit programme d'ordinateur, comprenant un ensemble d'instructions de code de programme adaptées à mettre en oeuvre un procédé tel qu'exposé, lorsque ledit programme est exécuté sur un ordinateur.

L'invention vise sous un second aspect un procédé de création d'une bibliothèque de semi-équipements S-E-Library, lesdits semi-équipements, définis par des normes prédéterminées, étant destinés à être intégrés dans au moins un système électronique,
ce procédé étant tel que la bibliothèque S-E-Library comporte pour au moins un semi-équipement un algorithme de fonctionnement logique le représentant, présenté sous forme de blocs génériques de simulation (schémas fonctionnels graphiques formels), compatibles avec un langage de simulation.

Selon une mise en oeuvre particulière de ce procédé de création d'une bibliothèque de semi-équipements, les blocs génériques de simulation possèdent des entrées et des sorties identifiées.

Plus particulièrement, dans ce cas, dans une mise en oeuvre avantageuse le procédé de création d'une bibliothèque de semi-équipements comporte des sous-étapes de :
1- listage toutes les normes correspondant à tous les composants reliés aux extrémités de câbles d'un sous-système électronique que l'on veut simuler,
2- de codage, pour chaque norme, du semi-équipement correspondant, cette sous-étape comprenant des phases :
   2a - d'analyse de la nomenclature et de l'algorithme de fonctionnement du semi-équipement,
   2b - de codage de la logique du semi-équipement dans un bloc de simulation, sous forme de schéma fonctionnel graphique formel, interprétable par un logiciel de simulation.

Selon une mise en oeuvre encore plus particulière dans ce cas, les composants reliés aux extrémités de câbles d'un sous-système électronique que l'on veut simuler sont identifiés :
par création d'une table de câblage BD2 comprenant au moins pour chaque câble du système électronique à simuler, et pour chaque extrémité dudit câble, la référence de l'équipement auquel elle est connectée, la catégorie dudit équipement,
par extraction de ladite table de câblage BD2 d'entrées et sorties de tous les enregistrements correspondant aux câbles du système électronique,
et listage des normes des équipements connectés aux extrémités de ces dits câbles.

Selon une mise en oeuvre particulière de ce procédé de création d'une bibliothèque de semi-équipements, il comporte en outre une phase :
2c - de génération d'un équivalent en code C de la logique du semi-équipement, par à un outil de traduction automatique de blocs fonctionnels graphiques en code C, puis d'intégration dans la bibliothèque S-E-Library

Selon une mise en oeuvre particulière de ce procédé de création d'une bibliothèque de semi-équipements, les blocs de simulation sont compatibles avec le formalisme d'une base de spécifications de câblage préalablement choisie, c'est à dire que chaque bloc comporte la norme du semi-équipement simulé et que les entrées / sorties comportent le même nom que les broches des semi-équipements dans cette base de spécifications de câblage.

Selon une mise en oeuvre particulière de ce procédé de création d'une bibliothèque de semi-équipements, il comporte en outre
- une étape d'extraction, à partir d'une base de données de spécifications de câblage BD1, ladite base BD1 listant de façon exhaustive les entrées et sorties de chaque câble et comprenant notamment pour chaque câble : la nomenclature de ses deux extrémités, le type d'équipement relié à chaque extrémité, et les références de cet équipement, le système ou sous-système duquel dépend le câble, ladite base de données de spécifications de câblage BD1 correspondant au système électronique que l'on cherche à simuler, pour chaque composant listé dans cette base, de sa fréquence d'utilisation dans le câblage,
- et une étape de codage dans la bibliothèque S-E-Library des normes des composants, en se limitant aux composants qui présentent une fréquence d'utilisation supérieure à un seuil prédéterminé.

L'invention vise également un produit programme d'ordinateur, comprenant un ensemble d'instructions de code de programme adaptées à mettre en oeuvre un procédé de création d'une bibliothèque de semi-équipements tel qu'exposé, lorsque ledit programme est exécuté sur un ordinateur.

L'invention vise encore un circuit électronique, comportant une logique adaptée à mettre en oeuvre un procédé de création d'une bibliothèque de semi-équipements tel qu'exposé.

### Brève description des figures

Les buts et avantages de l'invention seront mieux compris à la lecture de la description et des dessins d'un mode particulier de réalisation, donné à titre d'exemple non limitatif, et pour lequel les dessins représentent :
Figure 1 : exemple de Planche de Câblage extraite de la base de données de câblage
Figure 2 : étapes de création de la bibliothèque de semi-équipements
Figure 3 : extraction de la base de données des entrées et sorties des câblages avion

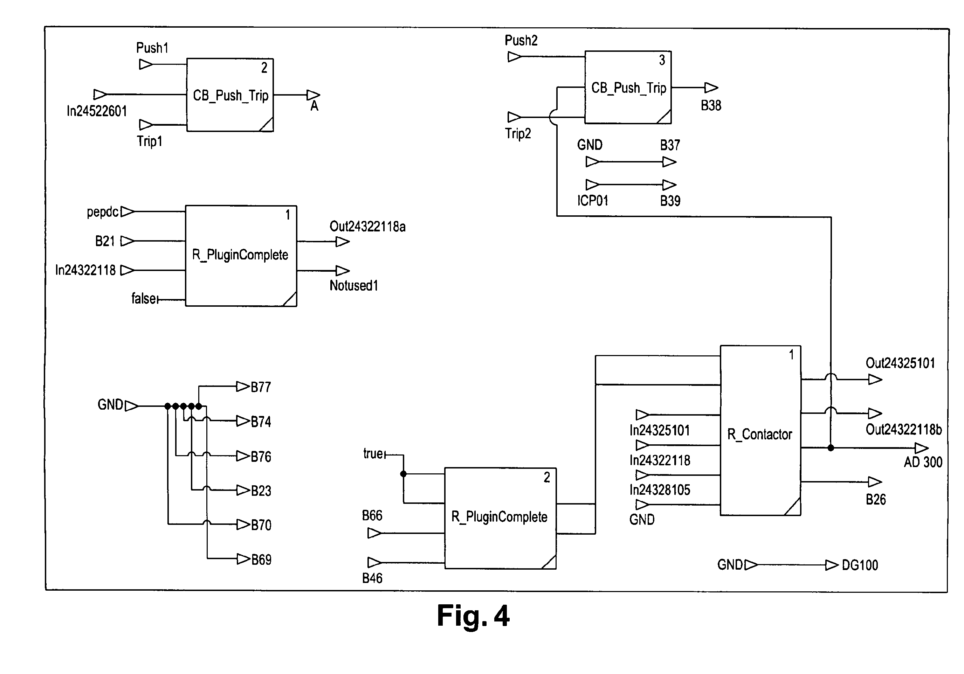

Figure 4 : planche de simulation sous forme de blocs graphiques fonctionnels
Figure 5 : schématique équivalente au semi-équipement référencé C/B 22PE
Figure 6 : schématique équivalente au semi-équipement référencé RTDO 19PE
Figure 7 : illustration schématique des étapes du procédé selon l'invention

### Description détaillée d'un mode de réalisation de l'invention

Pour la suite de la description, on appelle équipements tous les composants de type calculateurs, moteurs, composants hydrauliques, etc. de l'avion.

Par contre, les semi-équipements sont les composants 'de base' faisant le lien entre ces divers équipements. Pour en citer quelque-uns, les relais, les contacteurs, les disjoncteurs pour la partie électrique de l'avion.

Ces semi-équipements possèdent chacun des caractéristiques particulières de comportement et sont les éléments clef d'interconnexion entre les différentes parties du système avion.

On utilisera le terme modèle pour désigner les grandes fonctions de l'avion : électrique, hydraulique, fuel, moteurs etc., le terme système ou sous-système pour désigner un ensemble d'équipements et sous-équipements assemblés pour réaliser une fonction particulière de l'avion, et le terme composants pour désigner indifféremment les équipements et les semi-équipements.

Les composants sont reliés entre eux par des fils permettant de transférer entre eux des informations ou de la puissance, et formant un schéma de câblage

La description qui suit est donnée pour un schéma de câblage simple, qui ne comporte que quelques équipements et semi-équipements, et quelques dizaines de câbles, de manière à en faciliter la compréhension. Il reste évident que le procédé peut être étendu à un schéma de câblage arbitrairement grand, sans modification substantielle.

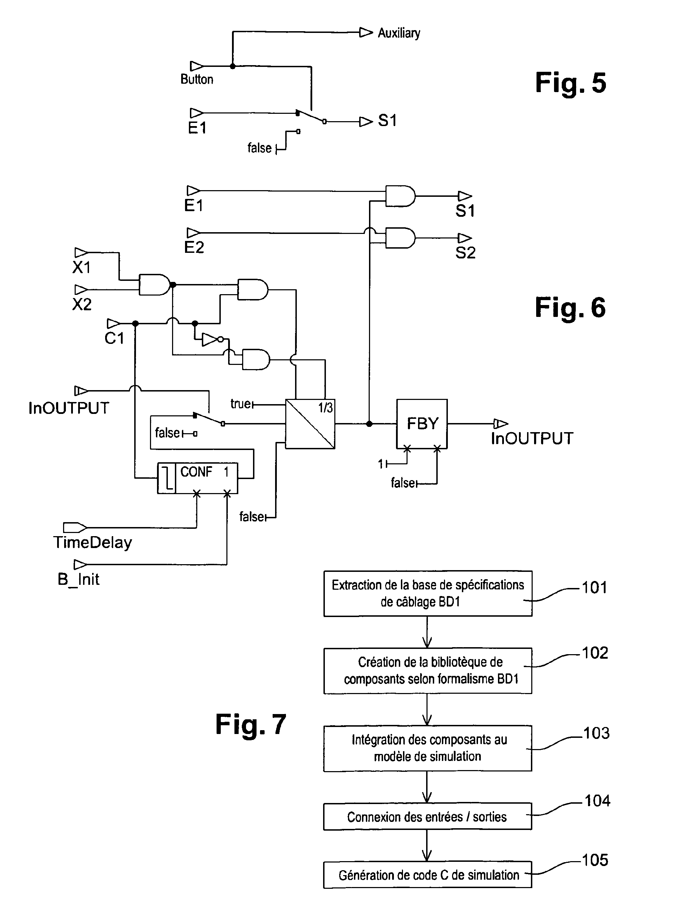

Les étapes principales du procédé de génération automatique de simulation d'un système avion sont illustrées sur un diagramme figure 7.

On note de façon préliminaire que le procédé selon l'invention est appelé à codé de façon logicielle et à être mis en oeuvre par un moyen informatique de type PC, ici supposé, de façon nullement limitative, relié en réseau à un serveur sur lequel sont stockées des bases de données de spécifications de composants de l'avion.

Ce PC est doté au moins des moyens logiciels connus de gestion de base de données, d'affichage, et d'un logiciel de simulation utilisant des schémas fonctionnels graphiques formels, par exemple un logiciel temps synchrone de conception par modèles de type connu sous le nom commercial SCADE (marque déposée).

Dans cette description, on considère, comme c'est en pratique le cas général, qu'il existe pour l'avion dont on cherche à simuler un système, une base de données de spécifications de câblage BD1 listant de façon exhaustive les entrées et sorties de chaque câble avion pour les différents systèmes.

Cette base BD1 est généralement disponible sous forme de fichiers de type tableurs ou, pour plus de commodité, sous forme visuelle de planches de câblage plus faciles à vérifier par les bureaux d'études.

Elle comprend entre autres pour chaque câble : la nomenclature de ses 2 extrémités, le type d'équipement relié à chaque extrémité et les références de cet équipement, des renvois aux planches de câblage incluant les positions auxquelles ce composant doit être dessiné sur la planche de câblage, le système (ATA, par exemple ATA 27 pour les commandes de vol, ATA 24 pour l'alimentation électrique, ATA 32 pour le train d'atterrissage etc.) ou sous-système (sous-ATA) duquel dépend le câble, etc.

Elle comprend également, pour tous les composants listés comme étant reliés aux extrémités des câbles avion, leur correspondance et leur nomenclature.

Les informations de cette base de données de spécifications de câblage BD1 sont pratiquement exhaustives pour tous les systèmes d'un avion, incluant les systèmes électriques, hydrauliques, fuel, moteurs etc.

De plus, cette base de données de spécifications de câblage BD1 est mise à jour à chaque évolution d'un avion en production.

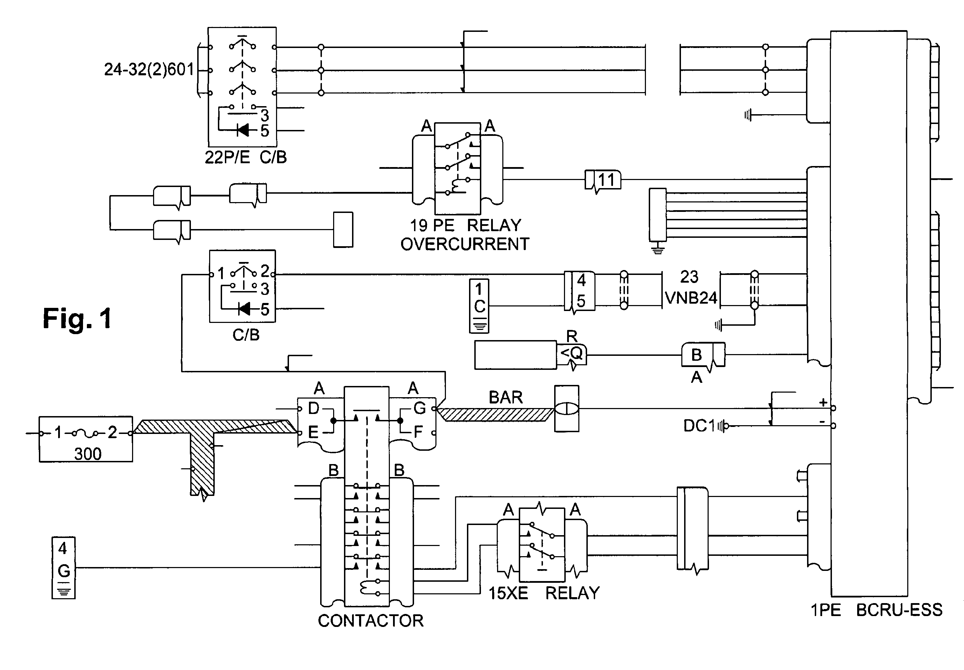

La figure 1 illustre une planche de câblage avion typique, extraite de la base de données de définition de câblages avion BD1 pour un sous-système du modèle électrique. Une telle planche de câblage définit pour un sous-système avion tous les fils reliant deux à deux un ensemble d'équipements figurés par des rectangles comportant des symboles internes représentatifs de leur fonction. On note que cette planche de câblage ne fournit pas d'informations sur le sens du courant circulant dans les différents câblages.

C'est un simple schéma de montage, pas un diagramme fonctionnel. Il ne comporte pas de logique en lui-même.

L'observation de la figure 1 montre qu'une planche de câblage typique comporte des équipements (calculateur 1), plusieurs semi-équipements (coupe circuit 2, 3, contacteur 4, relais surtenseur 5, relais 6, connecteur 12...), des connecteurs particuliers de type BusBars 7, 8, et des câbles de connexion entre ces divers composants, éventuellement reliés à des masses 10, 11.

Cette planche de câblage est reliée à d'autres planches par de nombreuses entrées sorties référencées typiquement "24-32(2)601" pour le coupe circuit 2, qui donnent le numéro du système concerné (ATA 24), le sous système et la référence du composant relié.

La simulation de cette planche de câblage doit donc impliquer la simulation de chacun de ces équipements, semi-équipements, connecteurs particuliers et câbles, et tenir compte des systèmes extérieurs auxquels la planche est reliée.

Si des blocs logiciels simulant les équipements existent de façon générique, et sont adaptés à être intégrés dans la simulation de toute planche de câblage, quelle que soit sa structure, il n'existe pas d'outil automatique de simulation des autres composants de la planche de câblage, ni de ses câbles eux-mêmes ou connecteurs particuliers.

La description qui suit propose un tel procédé automatique de création de simulation d'une planche de câblage.

La première étape 101 de ce procédé est une sélection et une extraction d'informations de la base de données de spécifications de câblage BD1 d'entrées et sorties de tous les câblages avion.

Dans un fichier sous forme de tableur correspondant à la base de données BD1 des entrées et sorties de chaque câble avion, chaque ligne fait référence à un câble et à ses deux extrémités.

A partir de la planche de câblage de la figure 1 ou de la base de données de spécifications de câblage BD1 équivalente, on extrait par un moyen logiciel connu, les différents 'fils' correspondant à ladite planche de câblage, et on créé une liste exhaustive de ces derniers.

Parmi toutes les informations disponibles dans la base de données BD1, on sélectionne certaines colonnes qui vont être pertinentes pour l'élaboration du procédé automatisé de génération de simulation.

En particulier, des champs 'et1' et 'ext2' de la base de données de spécifications de câblage BD1 contiennent le nom des composants (ex : le relais référencé 15XE) auxquels les deux extrémités d'un câble donné sont reliées.

Pour déterminer le type de composant qu'ils représentent, on se réfère à des champs de la base de données de spécifications de câblage BD1, qui comportent la norme correspondante à chaque composant relié à un câble (au relais référencé 15 XE correspond la norme E0247A0S).

Parmi les champs qui sont extraits de la base de données de spécifications de câblage BD1 et enregistrés dans un nouveau fichier BD2 (table de câblage TC), on trouve en particulier les suivants :
ATA : référence du sous-système concerné (Permettra d'éventuellement sélectionner l'ATA ou sous-ATA dont on veut créer le modèle.)
Ext1 : référence du composant auquel est relié le câble (ex 15XE) à son extrémité 1, et éventuellement la partie du composant
BrNormall : broche du composant 1 à laquelle le câble est relié
TypeEQ1 : catégorie du composant t relié à l'extrémité 1 du câble
Ext2 : référence du composant auquel est relié le câble à son extrémité 2, et éventuellement la partie du composant
BrNormal2 : broche du composant 2 à laquelle le câble est relié
TypeEQ2 : catégorie du composant relié à l'extrémité 2 du câble
Temp_RefSoILiasse : norme correspondant au composant de l'extrémité 1
Rep_RefSoILiasse : norme correspondant au composant de l'extrémité 2

Ceci représente donc les champs qui fournissent une information exhaustive concernant le listing de toutes les E/S intégrés au modèle sous forme de schémas fonctionnels graphiques formels.

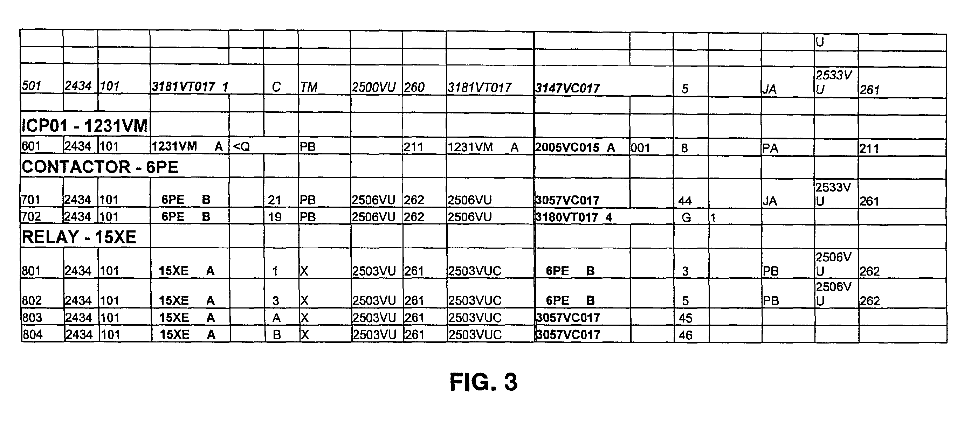

A partir des données brutes sélectionnées et extraites de la base de données de spécifications de câblage BD1 (planches de câblage), il est constitué une base de données dérivée BD2 (dite table de câblage) sous forme d'un nouveau fichier. Une extraction de la base de données de spécifications de câblage BD1, sous forme de tableur, est donnée en figure 3. On y retrouve des références de composants principaux de la planche de câblage de la figure 1, avec à titre d'exemple des données correspondant à certains des champs cités.

L'étape 102 consiste à établir une bibliothèque de semi-équipements S-E-Library sous forme de schémas fonctionnels graphiques formels (compatibles avec un logiciel de simulation de type SCADE - marque déposée) comprenant des blocs de simulation correspondant aux normes des divers semi-équipements listés dans les enregistrements de la table de câblage BD2.

En d'autres termes, cette bibliothèque de semi-équipements S-E-Library définit pour un ensemble de semi-équipements leur algorithme de fonctionnement logique, mémorisé sous forme de schéma fonctionnel graphique formel utilisant des blocs élémentaires de représentation prédéfinis.

Pour ce faire, il faut d'abord lister toutes les normes correspondant à tous les composants reliés aux extrémités de câbles, extraits du fichier sous forme de tableur de la table de câblage BD2 d'entrées et sorties de tous les câblages avion. Ceci revient à identifier un par un tous les composants sur la planche de câblage étudiée.

Puis, pour chaque norme correspondant à un composant listé dans la table de câblage BD2 des entrées et sorties de câbles avion (ou d'un sous-système que l'on veut simuler seul), le semi-équipement correspondant dans les planches de câblage est codé. La nomenclature et l'algorithme de fonctionnement du semi-équipement sont étudiés, puis sa logique est codée dans un bloc de simulation, sous forme de schéma fonctionnel graphique formel (par exemple en langage XML), interprétable par un logiciel de simulation de type SCADE (marque déposée).

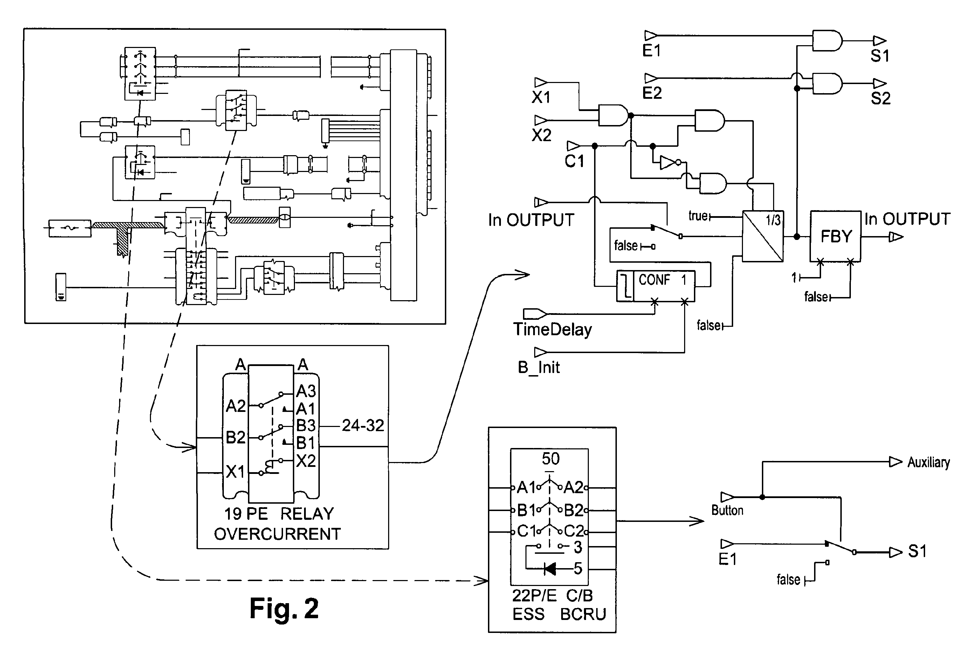

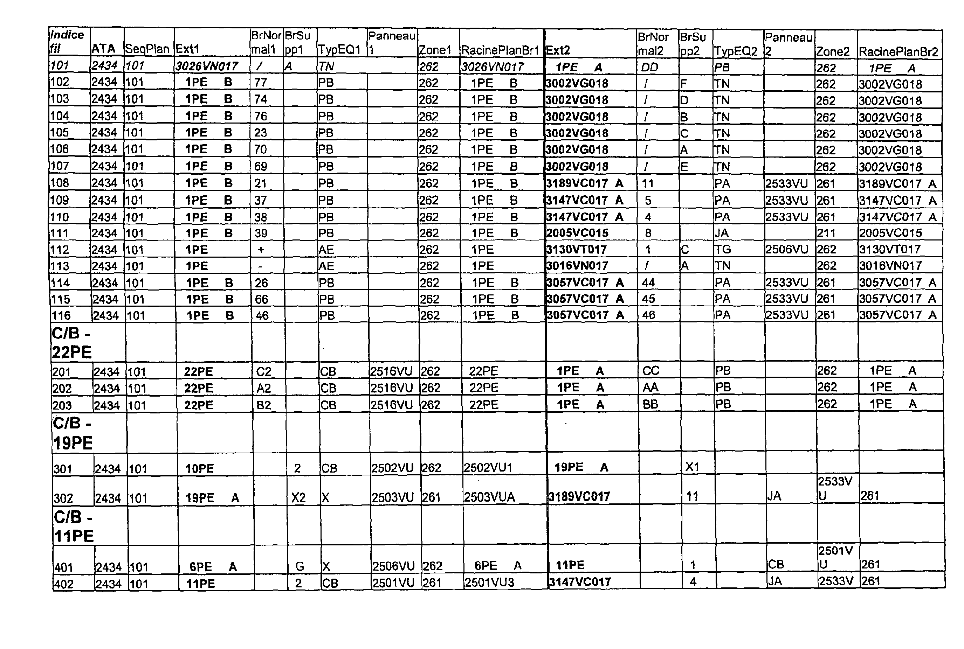

On donne en figure 2 un exemple montrant le ciblage de deux équipements 4, 5, sur la planche de câblage de la figure 1, leurs codes et leurs représentations graphiques respectives 4', 5' dans le logiciel de simulation.

Dans cet exemple, pour un semi-équipement référencé CB22P/E (composant 2 sur la figure 1), c'est à dire un composant connu sous la désignation usuelle de "Circuit Breaker with Auxiliary Contact", repéré dans la planche de câblage illustrée figure 2, l'algorithme associé est le suivant :
If Push=1
Then S1=0 AND Auxilary=1
Else S1=E1
Et la schématique associée sous forme de graphiques formels est illustrée figure 5. Cette schématique est une présentation formelle équivalente à un codage du mode de fonctionnement de ce semi-équipement en langage C ou autre. Une telle schématique est donc utilisable dans un logiciel de simulation d'un système avion.

De même, pour le semi-équipement (noté 5 sur la figure 1) référencé R/TDO (« Plug in time delay opening relay »), l'algorithme logique est :
IF X1=1 AND X2=1
Then S1=E1 and S2=E2
Else if (X1=0 and X2=1) or (X1=1 and X2=0) or (X1=0 and X2=0) during (at least) `TimeDelay'
Then S1=0 and S2=0
Et sa schématique associée est illustrée figure 6

La bibliothèque S-E-Library est ainsi constituée de blocs de simulation représentant la plupart des semi-équipements qui peuvent ainsi être intégrés de manière générique aux modèles de simulation. Ces blocs génériques possèdent des entrées et des sorties identifiées.

Le rôle de cet outil est d'être utilisé comme entrée du procédé automatique de génération des planches de simulation et ainsi de relier les calculateurs et les semi-équipements automatiquement en respectant le formalisme des planches de câblage.

Une fois, les semi-équipements repérés, spécifiés et codés suivant la logique de schémas fonctionnels graphiques formels, leur équivalent en code C est généré automatiquement grâce à un outil connu de traduction automatique de blocs fonctionnels graphiques en code C, puis intégré dans une bibliothèque S-E-Library, utilisable par un logiciel écrit dans le même langage.

Les blocs de simulation doivent être compatibles au formalisme de la base de données de spécifications de câblage BD1, c'est à dire que chaque bloc doit comporter la norme du semi-équipement simulé et les entrées / sorties doivent comporter le même nom que les broches des semi-équipements sous BD1.

Cette bibliothèque S-E-Library est ici décrite pour le modèle électrique de l'avion mais peut naturellement être étendue aux autres modèles de l'avion (Hydraulique, Fuel, Moteurs,...).

On comprend que cette étape 102 peut être mise en oeuvre soit par un opérateur humain, soit avantageusement, au moins pour certaines parties, par un programme informatique,
par exemple pour extraire les données nécessaires d'une base de données de câblage,
ou pour analyser la nomenclature du semi-équipement selon une base de données préexistante, ou comparer ce composant à des composants proches déjà identifiés,
ou pour tester directement le composant de manière à déterminer son algorithme (c'est-à-dire sa fonction de transfert),
ou pour coder dans un langage prédéterminé un algorithme, écrit sous forme de phrases logiques.

Les composants listés dans la table de câblage BD2 sont alors intégrés (étape 103) à un méta modèle de simulation sous forme de schémas fonctionnels graphiques formels en un seul noeud ou en plusieurs noeuds, chaque noeud représentant un système (« ATA »), ces systèmes échangeant des informations entre eux. On rappelle qu'un modèle de simulation se présente mathématiquement sous forme d'un graphe, dont les noeuds correspondent à des systèmes reliés par des interactions fonctionnelles.

Cette intégration se fait au moyen de la bibliothèque sous forme de schémas fonctionnels graphiques forme en appelant les différents semi-équipements simulés en fonction des normes listées.

Cette tâche est dans le présent exemple réalisée par une macro établissant le listing des semi-équipements dans la table de câblage BD2, appelant les divers blocs de simulation de la bibliothèque S-E-Library sous forme de schémas fonctionnels graphiques formels en fonction de la norme de ces semi-équipements et attribuant un nom à ces semi-équipements (le même nom que dans la base de données de spécifications de câblage BD1).

Dans le modèle généré, chaque noeud de simulation, simule un ATA et chaque équation de ce noeud simule les sous-ATA correspondant.

A titre d'exemple, le relais référencé 15XE A est listé avec la référence 'E0247A0S'. Il appelle le bloc de simulation référencé sous le même nom et est intégré au noeud général ou au noeud 24 (pour l'ATA 24, système électrique avion), équation 24, sous le nom 15XE A.

Un exemple de planche de simulation partielle correspondant à la planche de câblage de la figure 1 est illustrée en figure 5. On y reconnaît les blocs de simulations 2', 3', 4', 5', 12' correspondant respectivement aux composants 2, 3, 4, 5, 12 de la planche de câblage. Les blocs de simulation sont ici figurés par des rectangles, leur logique interne étant définie dans la bibliothèque S-E-Library (on a vu les exemples des blocs de simulation des composants 2 et 5), et leurs entrées et sorties étant signalées avec les broches des composants reliés ou les entrées logiques associées.

L'étape 104 est alors la génération du modèle.

Dans cette étape 104, on crée une table de simulation TS par transformation de chaque ligne de la table de câblage BD2 en utilisant des règles de transformation spécifiques à chaque couple d'équipements connectés aux deux extrémités de chaque câble,

Plus précisément, une fois tous les semi-équipements d'un ATA, d'un sous-ATA, ou de tout le système avion intégrés dans la 'trame' du modèle final (étape 103), le but est de relier les entrées / sorties entre elles.

L'un des problèmes ici posés est celui du sens des câbles reliant les composants deux à deux, puisque la base de données de spécifications de câblage BD1 caractérise des données de liaison de composants par des câbles de façon statique, et non des données de fonctionnement. Il ne s'agit donc pas d'un diagramme fonctionnel (« Field Diagram » ou FD en langue anglo-saxonne).

Une macro dans le logiciel de simulation travaillant sous forme de blocs graphiques fonctionnels a été créée. Cette macro a pour but de connecter les entrées et les sorties des composants grâce à la base de données de spécifications de câblage BD1 d'entrées et sorties de câblages.

Les deux entrées de cette macro sont donc :
1 / d'une part, la table de câblage BD2 des entrées et sorties de chaque câble avion
2/ d'autre part, la trame du modèle (les blocs de simulations des équipements et sous-équipements extraits de la bibliothèque si ils font partie des composants reliés aux extrémités de câbles listés dans la table de câblage BD2) générée comme décrit dans l'exemple simplifié.

Ainsi, on rappelle que pour chaque ligne dans le nouveau fichier sous forme de tableur de la table de câblage BD2 correspond un fil et ses deux extrémités qui correspondent chacune à une entrée et une sortie des semi-équipements déjà présents dans le modèle.

Le but est donc d'extraire un à un ses fils et de les connecter par l'intermédiaire de la macro qui contient la logique et les hypothèses suivantes :
→ Les champs 'ext1' et 'ext2' pointent vers les références des deux équipements ou semi-équipements à relier dans le logiciel de simulation
→ Les champs 'BrNormal1' et 'BrNormal2' pointent vers les broches des semi-équipements à relier.
→ Les champs 'TypeEQ1' et 'TypeEQ2' renseignent sur le catégorie des composants reliés. En effet, certains semi-équipements ne sont pas codés dans la bibliothèque sous forme de schémas fonctionnels graphiques formels (étape 103) et donc non intégrés à la trame du modèle comme par exemple les masses, les blocs de terminaison, etc. Il faut donc inclure au code une valeur par défaut pour ces éléments (ex : 1 pour les masses).
→ Concernant les connecteurs, les deux composants reliés à la même broche d'un connecteur sont reliés par le même fil.
→ Dans le cas où on ne simule pas tout le système avion, mais seulement un sous-système, des E/S ne sont pas internes au modèle, elles doivent donc être référencées en tant que telles (« NotUsed »+Référence du semi-composant+récurrence). Si c'est une entrée non référencée dans le modèle, on choisit de la fixer à une valeur par défaut (par exemple 1).

La macro prend en compte toutes les entrées / sorties des composants intégrés au modèle sous forme de schémas fonctionnels graphiques formels et les relie.

Cette macro peut, par exemple, parcourir la table de câblage BD2 ligne à ligne, et procéder au fur et à mesure au chargement des blocs logiciels de simulation de la bibliothèque de semi-équipements S-E-Library correspondant aux composants d'extrémités de câbles, incorporés au code sous forme de procédures, puis effectuer le traitement des câbles eux-mêmes en déterminant le sens de parcours du courant qui les traverse, et leur codage équivalent.

La détermination, pour toutes les origines et destinations (Ext1 et Ext2) des câblages avion, de leur nature entrée ou sortie utilise un algorithme comme suit :
1/ pour tous les composants listés dans la bibliothèque de semi-équipements S-E-Library, on définit les liens possibles entre les broches des connecteurs de ce composant,
2/ puis on identifie au moins un de ces points comme devant obligatoirement être une entrée ou une sortie, à partir de règles initiales utilisant la définition graphique formelle des semi-équipements,
3/ puis enfin on propage par cheminement (par exemple l'extrémité opposée d'une « Entrée » sur un câble est nécessairement une « Sortie ») la nature des différentes extrémités de tous les câbles du système à simuler.

Des exemples de règles à titre non limitatif sont donnés ici :
Règle 1 : dans un semi-équipement type relais, les broches X et Z sont des Entrées
Règle 2 : dans un semi-équipement connu sous le nom usuel de "Circuit Breaker" triphasé, les broches A2, B2, C2 sont des Entrées

Pour les câbles dont les extrémités ne sont pas reliées à des composants faisant partie de la bibliothèque S-E-Library de semi-équipements :
Règle 3 : Si le champ « Pin-Type » présente la valeur I (in) ou si le symbole est de type « Circuit Breaker », l'extrémité est une Entrée
Règle 4 : Si le champ « Pin-Type » présente la valeur O (Out), l'extrémité est une Sortie

Si une masse est câblée vers une broche d'un composant, l'extrémité du câble relié à cette masse est une Entrée, et de façon analogue, la valeur logique « TRUE » est associée à cette masse.

Si le composant est un contacteur disjoncteur différentiel RCCB (Residual Current Circuit Breaker en langue anglo-saxonne), alors :
Règle 5 : les broches référencées cmd1 et cmd2 sont des Sorties
Règle 6 : la broche d'alimentation de la charge est une Entrée.

Dans la macro qui génère les lignes de code XML (ou autre compatible avec le logiciel de type SCADE - marque déposée) définissant les blocs de simulation, on a choisi de garder les coordonnées d'implantation des composants de la planche de câblage initiale, comme coordonnées d'implantation sur la visualisation de la planche de simulation. Ces données avaient à dessein été extraites de la base de données de spécifications de câblage BD1, et sauvées dans la table de câblage BD2.

De cette manière, la vérification par les développeurs de modèles de la conformité de la planche de simulation à la planche de câblage est grandement facilitée, car on obtient une superposition visuelle des planches, les blocs de simulation de chaque composant se superposant au schéma du composant, et les câbles orientés se superposant aux câbles de la planche de câblage.

On comprend que la description précédente couvre un procédé d'automatisation de génération des modèles de simulation, permettant de relier les modèles de simulation des calculateurs et autres composants principaux, avec des blocs de simulation représentant les semi-équipements, à l'aide des données contenues dans les planches de câblage (base de données listant de façon exhaustive les entrées et sorties de chaque câble avion pour les différents systèmes).

On peut donc à partir de la base de données de spécifications de câblage BD1 d'entrées et de sorties de tous les câblages avion, réaliser, de façon automatique, un méta modèle sous forme de schémas fonctionnels graphiques formels, dans lequel on retrouve tous les équipements et semi-équipements du système avion, reliés entre eux.

Ce méta modèle est alors codé dans un langage informatique tel que C ou Ada et intégré directement à un simulateur avion (étape 105).

L'étape 105 consiste donc en la génération d'un code interprétable par un simulateur.

Dans cette étape 105, on crée un ensemble d'instructions de code informatique interprétable par un simulateur, par transformation de chaque ligne de la table de simulation TS en un ensemble de lignes de code informatique selon les équipements d'entrée et de sortie.

Le procédé qui vient d'être décrit présente de nombreux avantages :
Le procédé garantit une meilleure qualité, une meilleure traçabilité et une validation sécurisée des modèles de simulation du fait de l'information exhaustive des câbles avions dans la base de données de spécifications de câblage BD1
La macro développée dans le logiciel travaillant sous forme de blocs graphiques fonctionnels n'a pas besoin de mises à jour importantes et l'avantage du développement d'un tel procédé et qu'il peut être facilement réactualisé et appliqué sur plusieurs types d'appareils, avec un coût de maintenance peu élevé.

Il a été développé une bibliothèque S-E-Library sous forme de schémas fonctionnels graphiques formels (par exemple en langage XML, de type SCADE - marque déposée) de symboles génériques (GSB) simulant les principaux semi-équipements électroniques. Ces symboles, validés et compilés, peuvent être intégrés génériquement aux modèles de simulation sans faire l'objet d'un codage manuel qui pourrait se révéler différent selon qu'il est effectué par un développeur de modèles ou un autre.

Cette bibliothèque S-E-Library fournit une information complète sur la totalité des semi- équipements utilisées et ne nécessite que de peu d'évolutions pour les futurs avions.

### Variantes de l'invention

La portée de la présente invention ne se limite pas aux détails des formes de réalisation ci-dessus considérées à titre d'exemple, mais s'étend au contraire aux modifications à la portée de l'homme de l'art.

Pour l'étape de création 102 de bibliothèque S-E-Library de blocs de simulation, on sait qu'il existe classiquement plusieurs dizaines de milliers de normes dans la base de données de spécifications de câblage d'un avion, et que la création de la bibliothèque de blocs de simulation correspondants S-E-Library est un travail considérable.

Dans une variante, il est possible d'extraire de la base de données BD1 pour chaque composant listé, sa fréquence d'utilisation dans le câblage avion, et de procéder au codage des composants dans la bibliothèque S-E-Library en commençant par les plus souvent utilisés.

Le procédé selon l'invention peut alors être modifié pour signaler lors d'une demande de création de simulation d'un système quels composants ne sont pas encore codés dans la bibliothèque S-E-Library. Il est alors possible soit de compléter la bibliothèque de composants S-E-Library, soit de proposer automatiquement au Développeur de Modèles qui utilise le procédé des composants équivalents ou proches.

On comprend que l'ensemble du procédé de génération de simulation numérique fonctionnelle d'un système électronique qui a été décrit peut être mis en oeuvre par un logiciel implanté sur un ordinateur. Il peut également être mis en oeuvre par un circuit électronique dédié, par exemple mais non limitativement de type FPGA, comportant une logique adaptée à mettre en oeuvre le procédé tel que décrit.

De la même manière, le procédé de génération de simulation numérique fonctionnelle d'un système électronique, tel que décrit, peut faire partie intégrante d'un simulateur de système électronique, en tant que première étape dans le fonctionnement dudit simulateur, servant à le configurer selon le système électronique à simuler.

## Revendications

1. Procédé de création d'une bibliothèque de semi-équipements S-E-Library, lesdits semi-équipements, définis par des normes prédéterminées, étant destinés à être intégrés dans au moins un système électronique,
le procédé comportant une étape de création, pour au moins un semi-équipement, d'un algorithme de fonctionnement logique le représentant, présenté sous forme de blocs génériques de simulation (schémas fonctionnels graphiques formels), compatibles avec un langage de simulation,
les blocs génériques de simulation possédant des entrées et des sorties identifiées,
**caractérisé en ce que** le procédé comporte des sous-étapes:
1-de listage de toutes les normes correspondant à tous les semi-équipements reliés aux extrémités de câbles d'un sous-système électronique que l'on veut simuler,
2-de codage, pour chaque norme, du semi-équipement correspondant, cette sous-étape comprenant des phases :
2a - d'analyse de la nomenclature et de l'algorithme de fonctionnement du semi-équipement,
2b - de codage de la logique du semi-équipement dans un bloc de simulation, sous forme de schéma fonctionnel graphique formel, interprétable par un logiciel de simulation.

2. Procédé selon la revendication 1, **caractérisé en ce qu'**il comporte également une sous-étape d'extraction automatique d'au moins une partie des normes correspondant à des semi-équipements reliés aux extrémités de câbles, d'un fichier sous forme de tableur d'une table de câblage BD2 d'entrées et sorties de câblages d'un système électronique à simuler.

3. Procédé selon l'une des revendications 1 ou 2, **caractérisé en ce qu'**il comporte une sous-étape d'analyse de la norme d'au moins un semi-équipement selon une base de données préexistante.

4. Procédé selon l'une des revendications 1 à 3, **caractérisé en ce qu'**il comporte une sous-étape d'analyse de la norme d'au moins un semi-équipement par comparaison de ce semi-équipement à des semi-équipements similaires déjà identifiés.

5. Procédé selon l'une des revendications 1 à 4, **caractérisé en ce qu'**il comporte une sous-étape de test direct d'au moins un semi-équipement de manière à déterminer son algorithme (c'est-à-dire sa fonction de transfert).

6. Procédé selon l'une des revendications 1 à 5, **caractérisé en ce qu'**il comporte des sous-étapes :
d'extraction d'une base de données, pour chaque semi-équipement listé, de sa fréquence d'utilisation dans le câblage du système électronique à simuler,
de codage des semi-équipements dans la bibliothèque S-E-Library en commençant par les plus souvent utilisés,
de signalement, lors d'une demande de création d'une simulation du système, quels semi-équipements ne sont pas encore codés dans la bibliothèque S-E-Library,
de complétion de la bibliothèque de semi-équipements S-E-Library, ou de proposition à l'utilisateur du procédé, de semi-équipements équivalents ou proches.

7. Procédé selon l'une quelconque des revendications précédentes, **caractérisé en ce que** les blocs de simulation sont compatibles avec le formalisme d'une base de spécifications de câblage préalablement choisie, c'est à dire que chaque bloc comporte la norme du semi-équipement simulé et que les entrées / sorties comportent le même nom que les broches des semi-équipements dans cette base de spécifications de câblage.

8. Procédé selon l'une quelconque des revendications précédentes, **caractérisé en ce qu'**il comporte en outre
- une étape d'extraction, à partir d'une base de données de spécifications de câblage BD1, ladite base BD1 listant de façon exhaustive les entrées et sorties de chaque câble et comprenant notamment pour chaque câble : la nomenclature de ses deux extrémités, le type d'équipement relié à chaque extrémité, et les références de cet équipement, le système ou sous-système duquel dépend le câble, ladite base de données de spécifications de câblage BD1 correspondant au système électronique que l'on cherche à simuler, pour chaque composant listé dans cette base, de sa fréquence d'utilisation dans le câblage,
- et une étape de codage dans la bibliothèque S-E-Library des normes des composants, en se limitant aux composants qui présentent une fréquence d'utilisation supérieure à un seuil prédéterminé.

9. Produit programme d'ordinateur, comprenant un ensemble d'instructions de code de programme adaptées à mettre en oeuvre un procédé selon l'une quelconque des revendications précédentes, lorsque ledit programme est exécuté sur un ordinateur.

10. Circuit électronique, **caractérisé en ce qu'**il comporte une logique adaptée à mettre en oeuvre un procédé selon l'une quelconque des revendications précédentes.
